# EUROPÄISCHE PATENTSCHRIFT

(11) **EP 0 404 082 B1**
(45) Veröffentlichungstag und Bekanntmachung des Hinweises auf die Patenterteilung: **24.01.1996**
(21) Anmeldenummer: 90111599.8
(22) Anmeldetag: 20.06.1990
(51) Int. Cl.: F16K 31/00, F16K 31/02, H01L 41/08

(54) **Piezoelektrischer Biegewandler und seine Verwendung**
Piezoelectric bending transducer and its usage
Transducteur de pliage piézoélectrique et son utilisation

(30) Priorität: 22.06.1989 DE 3920368; 25.10.1989 DE 3935474
(43) Veröffentlichungstag der Anmeldung: 27.12.1990
(73) Patentinhaber: Hoechst CeramTec Aktiengesellschaft, D-95100 Selb (DE); HOERBIGER FLUIDTECHNIK KG, A-1040 Wien (AT)
(72) Erfinder: Uhl, Thomas, D-8672 Selb (DE); Frisch, Herbert, A-1238 Wien (AT)
(74) Vertreter: Hoffmann, Peter, Dipl.-Chem.

(56) Entgegenhaltungen:
- EP-A- 0 043 456
- DE-A- 3 400 645
- DE-A- 3 608 550
- US-A- 3 152 612
- US-A- 4 237 399
- US-A- 4 340 083
- US-A- 4 492 360
- US-A- 4 545 561

## Beschreibung

Die Erfindung betrifft einen piezoelektrischen Biegewandler gemäß Oberbegriff von Ansprüch 1. Derartige Biegewandler sind aus der US-PS 4,237,399 bekannt.

Aus der DE-OS 36 08 550 ist ein piezo-elektrisch betätigbares Ventil bekannt, das in einem Gehäuse eine langgestreckte einseitig eingespannte Piezokristall-Anordnung enthält, die mit einer elektrischen Spannungsquelle verbindbar ist. Das freie (bewegliche) Ende der Piezokristall-Anordnung ist mit einem Dichtkörper versehen. Bei Anlegen einer ausreichenden Spannung führt der Piezokristall eine seitliche Bewegung aus. Damit kann der Dichtkörper einen Ventilkanal verschließen.

Nachteilig an dieser Konstruktion ist, daß das Aufbringen von Dichtkörpern auf den Piezokristall einen zusätzlichen Arbeitsgang erfordert, und die Masse des Biegewandlers erhöht, d.h. dessen Eigenresonanz erniedrigt. Der Biegewandler verliert daher an Schnelligkeit. Es können daher weniger Schaltzyklen pro Zeiteinheit gefahren werden. Da die Dichtkörper auch Platz benötigen, wird eine Miniaturisierung des Ventiles erschwert.

Es bestand daher die Aufgabe, ein Biegeelement für den Einsatz in Ventilen anzugeben, das konstruktiv so ausgelegt ist, daß die angegebenen Nachteile für den Ventilhersteller vermieden werden.

Die Erfindung geht von der Erkenntnis aus, daß auch die piezokeramische Schicht selbst zum Abdichten eines Ventilkanals geeignet ist, wenn die Rauhigkeit der Oberfläche unter 0,5 µm liegt. Bei einer üblichen Metallisierung der Piezokeramik, die für die spätere Erzeugung der Feldstärke notwendig ist, werden jedoch höhere Rauhigkeitswerte erhalten.

Es wurde nun ein piezoelektrischer Biegewandler gefunden, der als wesentliche Bestandteile
a) mindestens eine beidseitig metallisierte piezoelektrische Keramikschicht, die so polarisiert ist, daß sie bei Anlegen einer Spannung eine Längenänderung erleidet und
b) ein damit flächig verbundenes steifes Formstück mit etwa gleichen Flächenabmessungen, das bei Anlegen einer Spannung keine oder eine entgegengesetzte Längenausdehnung erleidet,
enthält. Der Biegewandler ist dadurch gekennzeichnet, daß die Keramikschicht auf mindestens einer Seite eine nicht-metallisierte Stelle mit einer Rauhigkeit Rₐ von unter 0,5 µm aufweist. Diese nicht-metallisierte Stelle soll sich in der Zone maximaler Auslenkung befinden, wenn der Biegewandler mit einer Spannungsquelle verbunden und geeignet eingespannt wird. Die nicht-metallisierte Stelle soll etwas größer sein als der abzudeckende Ventilkanal. Die Metallisierung der Piezoschichten erfolgt üblicherweise durch Siebdruck. Um ein Herabfließen der Druckpaste am Schichtrand oder ein späteres Überspringen von Funken am Rand zu vermeiden, läßt man üblicherweise am Rand einen schmalen, etwa 0,3 mm breiten Streifen unbedruckt. Ein solcher Streifen reicht für die Abdeckung eines Ventilkanals nicht aus. Die nicht-metallisierte Stelle soll die Mindestabmessungen 1 x 1 mm aufweisen.

Je kleiner der Anteil der nicht-metallisierten Stelle an der gesamten beweglichen Fläche ist, umso geringer ist die Einbuße an Auslenkung des Biegewandlers bei Anlegen einer festgelegten Spannung. Der nicht-metallisierte Bereich soll daher möglichst eng zusammenhängend sein.

Das steife flächige Formstück kann aus einem beliebigen Material bestehen, z.B. ein Metallblech sein (keine piezoelektrischen Eigenschaften) oder ebenfalls eine beidseitige metallisierte Keramikschicht mit piezoelektrischen Eigenschaften. Durch geeignete Polarisierung der verwendeten Piezoschichten und Beachten des Vorzeichens der angelegten Spannung läßt sich erreichen, daß beide Schichten eine entgegengesetzte Längenausdehnung erleiden, was zu einer Krümmung des Biegewandlers, d.h. zu einer Bewegung etwa senkrecht zur Flächenrichtung führt.

Die metallisierte Keramikschicht hat vorzugsweise die Form eines langgestreckten, meist rechteckigen Streifens. Die nicht-metallisierte Stelle befindet sich dann an einem schmalen Ende des Streifens. Bei einer Verwendung in einem Ventil wird der Streifen am anderen Ende einseitig eingespannt und mit Spannung versorgt.

Ein solcher Streifen weist i.a. das Verhältnis Länge/Breite von 1:2 bis 1:4 auf. Der nicht-metallisierte Bereich soll so groß sein, daß er ein Rechteck abdeckt, dessen Länge der Breite mindestens gleichkommt und dessen Breite mindestens 1 mm, noch besser mindestens 2 mm beträgt. Vorzugsweise liegt das Verhältnis Länge/Breite im Bereich von 1:1 bis 4:1. Beispielsweise kann man an einem Streifen aus Piezokeramik der Fläche 25 x 10 mm einen rechteckigen Bereich von 2,3 x.7,4 mm oder 2 x 10 mm oder einen kreisförmigen Bereich (Durchmesser 1,5 - 2,5 mm) ohne Metallisierung belassen. Für das Abdecken von runden Ventilöffnungen sind kreisförmige Bereiche besser. Aus fertigungstechnischen Gründen lassen sich rechteckige Bereiche leichter metallisierungsfrei herstellen.

Es ist ferner möglich, der Keramikschicht mit piezoelektrischen Eigenschaften eine Kreisform zu geben und die nicht-metallisierte Stelle etwa in Kreismitte anzuordnen. Ein solcher Biegewandler wird am Rand eingespannt und der Bereich, der bei Anlegen einer Spannung am stärksten auslenkt, befindet sich ebenfalls in der Kreismitte.

Bei einem Biegewandler, der die Form eines langgestreckten Streifens aufweist, ist es auch möglich, metallisierungsfreie Zonen auf oberster und unterster Keramikplatte des Verbundes vorzusehen. Damit kann erreicht werden, daß in einem Ventil je nach der Auslenkung des Streifens die eine oder die andere Seite einen Ventilkanal abdeckt. Dies erlaubt die Konstruktion eines Ventils mit drei Ventilkanälen und nur einem Biegewandler.

Zur Herstellung von piezoelektrischer Keramik (z.B. auf der Basis Blei-Zirkonat-Titanat) setzt man als Ausgangsmaterialien in den überwiegenden Fällen Pulver von Metalloxiden und Metallkarbonaten ein. Durch das Kalzinieren erhält man als Ergebnis einer Festkörperreaktion bereits das Produkt mit der chemischen Endzusammensetzung. Andere Verfahren wie z.B. Kopräzipitation aus gelösten Ausgangsrohstoffen werden ebenfalls angewandt.

Nach dem Kalzinieren wird das Pulver meist einer zweiten Mahlung zur Verkleinerung des Korndurchmessers unterworfen. Während dieser Mahlung wird dem Pulver Flüssigkeit und Plastifikationsmittel zugesetzt, wodurch ein Schlicker entsteht. In der Regel wird dann der Schlicker durch ein Sprühverfahren getrocknet und in die gewünschte Form trockengepreßt.

Zur Herstellung dünner Teile werden dem Schlicker organische Plastifikationsmittel und Binder zugesetzt. Aus dem Schlicker erhält man durch Foliengießen dünne flexible Folien. Aus diesen Folien werden die Teile in der gewünschten Form ausgestanzt und nach Austreiben der vorhandenen organischen Substanzen gesintert. Danach werden die Teile mit Metallelektroden versehen.

Piezokeramiken mit geringer Dicke lassen sich auch durch Verpressen eines Piezomaterials in Blockform und Zersägen mittels geeigneter Sägen herstellen.

Nach dem Sinterbrand liegt die Keramik als polykristalliner Körper mit regellos verteilten elektrischen Dipolen vor, d.h. er zeigt noch keine piezoelektrische Aktivität. Erst durch den Vorgang der sogenannten Polarisation, d.h. Anlegen eines hohen elektrischen Feldes, werden die Dipole nahezu vollständig ausgerichtet.

Die Ausrichtung bleibt auch nach Abschalten des Polarisationsfeldes weitgehend erhalten und ist mit einer bleibenden Längenänderung des Körpers verbunden.

Weitere Einzelheiten zur Herstellung keramischer piezokristalliner Materialien sind dem Fachmann z.B. aus Ullmann, 4. Aufl., Enzyclopädie der Technischen Chemie, Bd. 11, S. 421 sowie Bauer, Bühling et al., "Technologie und Anwendung von Ferroelektrika", Akademische Verlagsgesellschaft, Leipzig, bekannt.

Dadurch, daß keine zusätzlichen Dichtelemente für ein Ventil notwendig sind, entfallen die Arbeitsgänge für die aufwendige Montage der Dichtelemente und die Bauform des Ventils kann sehr klein ausfallen.

Um auch im Niederspannungsbereich (24 Volt) arbeiten zu können, werden Keramikschichtdicken von unter 200 µm gewählt. In diesem Fall soll bei Anlegen einer Spannung von 24 Volt und nach Einspannung des Wandlers an dem metallisierten Streifenende eine solche Auslenkung an der nicht-metallisierten Stelle erfolgen, daß ein Ventilkanal sicher verschlossen wird.

Durch die Verwendung einer Zwischenschicht aus einem beliebigen Material, vorzugsweise eines Metallblechs, wird bei gleichbleibenden Keramikschichtdicken die Steifigkeit des Biegers erhöht, da sich der Abstand der Keramikplatten von der mittleren neutralen Zone vergrößert.

Dadurch erhöht sich die Eigenresonanz und damit die Schnelligkeit des Wandlers, was der Forderung des Anwenders nach immer schnelleren Schaltzyklen entgegenkommt.

Um rationell fertigen zu können, sind bei einem Bieger, der aus nur zwei Keramikschichten besteht, beide Keramikfolien im allgemeinen gleichsinnig polarisiert. Um die maximale Auslenkung zu erreichen, wird der Bieger so angesteuert, daß sich die eine Piezokeramikschicht verkürzt (das Feld in Polarisationsrichtung) während sich die andere Piezokeramikschicht verlängert (das Feld entgegen der Polarisationsrichtung). Dazu werden im praktischen Betrieb die beiden äußeren Elektroden von oberer und unterer Keramikplatte elektrisch miteinander verbunden und bilden z.B. den Minusanschluß, während die Mittelelektrode den Pluspol bildet.

Für sehr geringe Spannungen (z.B. 6 Volt) ist es auch möglich, mehrere (x), vorzugsweise 2 bis 8, beidseitig metallisierte, sehr dünne (100 µm und dünner) Piezokeramikschichten unter Verwendung von bis zu (x-1) Zwischenlagen aus leitfähigem Material miteinander zu verklebende, z.B. Zwischenlagen aus Blech, Kohlenstoff oder leitfähiger Keramik. Die Keramiken werden dann so polarisiert und elektrisch kontaktiert, daß sich bei einem Bieger mit z.B. 6 aktiven Keramikschichten die oberen drei Schichten verlängern, während sich die unteren drei Schichten verkürzen, wenn die Speisespannung angelegt ist.

Anstatt Metallblech mit metallisierter Piezokeramik oder zwei gesinterte, metallisierte Keramikfolien miteinander zu verkleben, ist es auch möglich, nicht gesinterte piezokeramische Rohfolien mit einem geeigneten Elektrodenmaterial zu versehen, zusammenzulaminieren und dann dem Sinterbrand zuzuführen, wobei ein monolithischer piezokeramischer Bieger entsteht. Da das Elektrodenmaterial Sintertemperaturen von 900°C bis 1200°C standhalten muß, ohne mit den Metalloxiden der Piezokeramik zu reagieren, eignen sich hierfür nur wenige Materialien, wie z.B. Platin.

Billiger und im Herstellungsprozeß einfacher ist ein Verkleben von gesinterten, metallisierten Piezokeramikplatten mit einem organischen Kleber, z.B. einem Einkomponenten-Methacrylat-Kleber.

Die Erfindung wird durch die Figuren näher erläutert: Figur la zeigt im Querschnitt einen piezoelektrischen Biegewandler in Streifenform bestehend aus zwei beidseitig metallisierten Keramikschichten (1, 2) und einer leitenden Zwischenschicht, z.B. einem Metallblech (3). Die Schichten 1 und 2 sind jeweils beidseitig mit der dünnen Metallisierungsschicht (4) überzogen. In der Figur ist an einem Ende des Streifens jeweils auf beiden Seiten ein kleiner Bereich (5) frei von Metallisierung. Dieser Bereich dient als Dichtfläche in Kontakt mit einem Ventilkanal (11). Verwendbar (für bestimmte Ventile) sind auch Biegewandler, die nur auf einer Seite einen nicht-metallisierten Bereich aufweisen.

In den Schichten (1) und (2) hat der Polarisationsvektor P die gleiche Richtung. Die beiden Schichten (1) und (2) sind auf die Zwischenschicht (3) aufgeklebt. Die dünne Kleberschicht ist nicht gezeichnet. Die Stromversorgung erfolgt durch die Drähte (6), (7) und (8). An dem Ende, das die Stromversorgung aufweist, wird später der Biegewandler mechanisch in der Halterung (9) eingespannt und gleichzeitig kontaktiert. Die Länge der beiden Piezoschichten ist nicht ganz gleich, damit an die Zwischenschicht leichter eine Stromzuführung angelötet werden kann. Ebenso gut könnte man beide Keramikschichten gleich lang und das Metallblech (3) etwas länger ausführen. Figur (1b) zeigt den gleichen Biegewandler in Aufsicht.

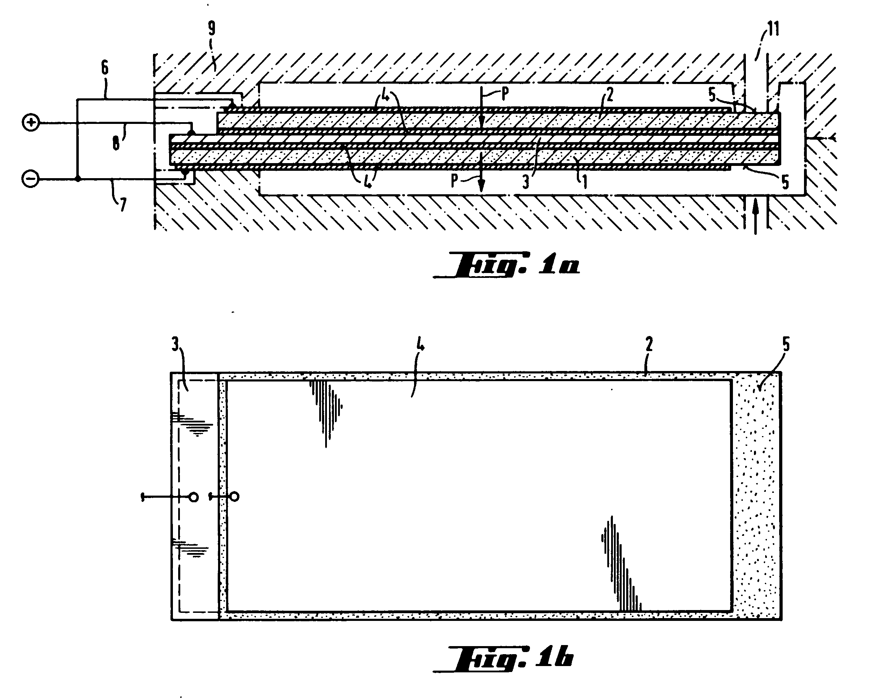

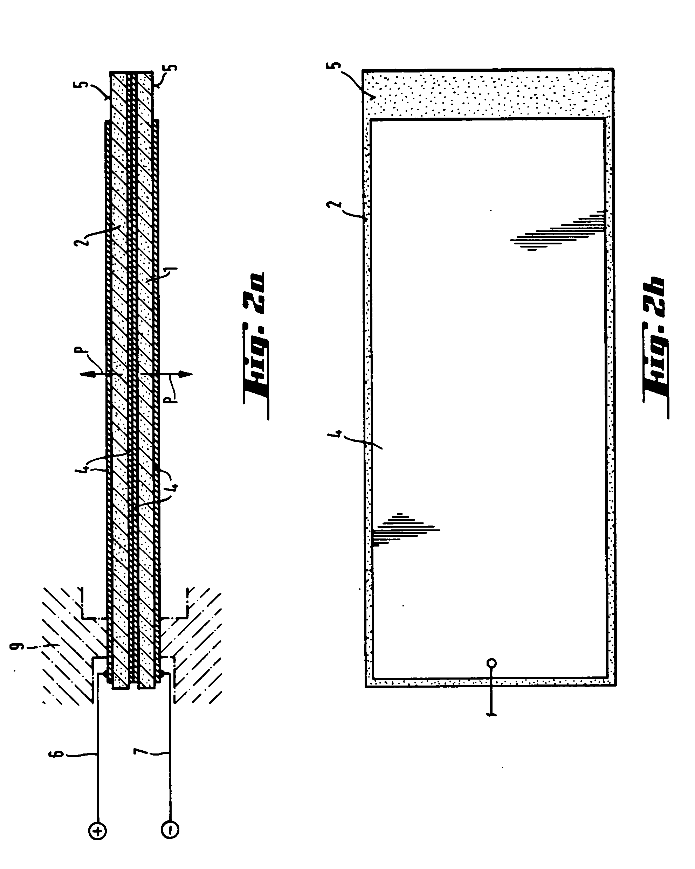

Figur 2a zeigt im Querschnitt einen Biegewandler in Streifenform, der aus zwei Piezokeramikschichten (1, 2), die jeweils die Metallsierungsschicht (4) tragen, besteht. Eine leitfähige Zwischenschicht fehlt. An einem Ende sind die Metallisierungsschichten (4) mit den Stromzuführungen (6, 7) verbunden. An gegenüberliegendem Ende des Streifens bleibt auf mindestens einer Seite ein kleiner Bereich (5) der Schicht ohne Metallisierung. Der Polarisierungsvektor P der beiden Schichten (1, 2) ist entgegengesetzt gerichtet. Figur 1b zeigt den gleichen Biegewandler in Aufsicht.

Figur (3a) zeigt im Querschnitt ein etwa kreisförmiges Biegeelement und einen durch das Biegeelement abzudeckenden Ventilkanal. Es enthält eine aktive piezokeramische Schicht (1), die beidseitig Metallisierungszonen (4) aufweist und mit einem kreisrunden Metallblech (3) verklebt ist (Kleber nicht gezeichnet). Das Metallblech (3) ist an seinem Rand mechanisch in eine leitfähige kreisrunde Halterung (9) eingespannt. Bei elektrischer Ansteuerung der Metallisierungszonen (4) durch die Stromzuführungen (6) und (7) wird der Verbundwandler abgelenkt. Die Auslenkung ist im Zentrum des kreisförmigen Verbundwandlers am größten. Dort befindet sich auch die metallisierungsfreie Zone (5), die sich an die Öffnung (10) des Ventilkanals (11) anlegt und dessen Abdichtung gewährleistet.

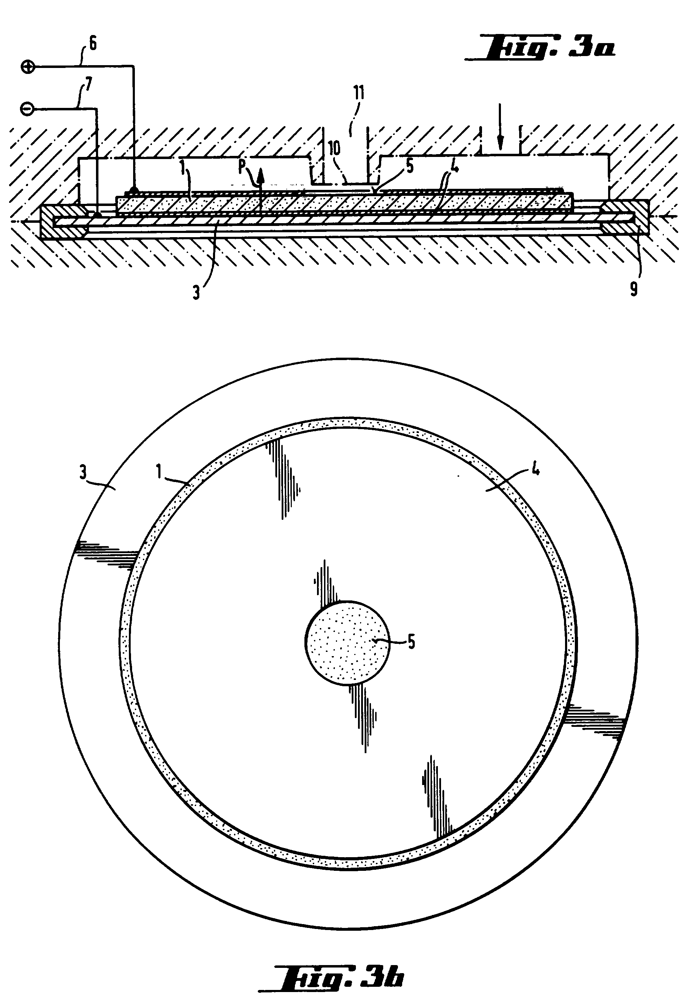

Figur 3b zeigt den gleichen Biegewandler (ohne Einspannung) in Aufsicht.

## Patentansprüche

1. Piezoelektrischer Biegewandler bestehend aus mindestens einer auf den beiden entgegengesetzten äußeren Oberflächen größter Aüsdehnüng metallisierten Keramikschicht (1) mit piezoelektrischen Eigenschaften, die so polarisiert ist, daß sie beim Anlegen einer elektrischen Spannung eine Längenänderung erleidet, und mindestens einem damit flächig verbundenen steifen Formstück (2, 3) mit etwa gleichen Flächenabmessungen, das beim Anlegen einer elektrischen Spannung keine oder eine entgegengesetzte Längenausdehnung erleidet, dadurch gekennzeichnet, daß die Keramikschicht mit piezoelektrischen Eigenschaften im Bereich maximaler Auslenkung auf einer der genannten Oberflächen eine nicht-metallisierte Stelle (5) mit einer Rauhigkeit Rₐ von < 0,5 µm und einer Flächenausdehnung von ≥ 1 mm aufweist.

2. Biegewandler gemäß Anspruch 1, dadurch gekennzeichnet, daß die Keramikschicht mit piezoelektrischen Eigenschaften Kreisform aufweist und die nicht metallisierte Stelle (5) sich etwa in der Kreismitte befindet.

3. Biegewandler gemäß Anspruch 1, dadurch gekennzeichnet, daß die Keramikschicht mit piezoelektrischen Eigenschaften die Form eines langgestreckten Streifens (1, 2) aufweist und die nicht-metallisierte Stelle (5) sich an einem schmalen Ende des Streifens befindet.

4. Biegewandler gemäß Anspruch 3, dadurch gekennzeichnet, daß er aus zwei miteinander verklebten beidseitig metallisierten Keramikschichten (1, 2) mit piezoelektrischen Eigenschaften besteht, die entgegengesetzt polarisiert sind und bei denen die beiden äußeren Metallisierungen mit den beiden Polen eine elektrische Spannungsquelle verbindbar sind.

5. Biegewandler gemäß Anspruch 3, dadurch gekennzeichnet, daß er zwei keramische Schichten (1, 2) enthält, die sandwichartig beidseitig auf einem nicht-leitenden Formstück (3) aufgeklebt sind, beide Schichten eine herumgezogene Kontaktierung (6, 7) aufweisen und jede Keramikschicht mit den Polen einer elektrischen Spannungsquelle verbindbar ist.

6. Biegewandler gemäß Anspruch 3, dadurch gekennzeichnet, daß er zwei Keramikschichten (1, 2) enthält, die sandwichartig beidseitig auf ein elektrisch leitfähiges flächenförmiges Formstück (3), insbesondere Metallblech aufgeklebt sind, beide Schichten in gleicher Richtung polarisiert sind und das leitfähige Formstück einerseits und die beiden äußeren Metallisierungen der Keramikschichten andererseits mit den beiden Polen einer elektrischen Spannungsquelle verbindbar sind.

7. Biegewandler gemäß Anspruch 6, dadurch gekennzeichnet, daß das leitfähige Formstück eine Kohlenstofffaser-Verbundplatte mit einer Dichte von 1.3-1.5 g/cm³ ist.

8. Verwendung des Biegewandlers gemäß Anspruch 1 als Steuerelement in einem elektrisch betätigten Ventil für Druckgase.

9. Piezoelektrisch betätigbares Ventil enthaltend ein Gehäuse mit zwei Ventilkanälen, und
a) einen im Inneren des Gehäuses einseitig eingespannten piezoelektrischen Biegewandler gemäß Anspruch 1 mit Anschlüssen zum Verbinden mit einer elektrischen Spannungsquelle, der so angeordnet ist, daß bei Abwesenheit einer elektrischen Spannung die nichtmetallisierte Stelle (5) des Streifens (1, 2) den ersten Ventilkanal berührt und verschließt und bei Anlegen einer Spannung diesen Ventilkanal freigibt, und
b) einen zweiten (nicht durch ein Ventil verschlossenen) Ventilkanal, durch den ein unter Druck stehendes Gas in das Innere des Gehäuses gelangen kann.

## Claims

1. A piezoelectric bending transducer, composed of at least one ceramic layer (1) which is metallized on the two opposite outer surfaces of greatest extent and has piezoelectric properties and which is polarized such that on application of an electric voltage it undergoes a change in length, and of at least one rigid molding (2, 3) which is joined to the whole surface thereof and has approximately the same surface dimensions and which on application of an electric voltage does not undergo an elongation or undergoes an opposite elongation, wherein the ceramic layer with piezoelectric properties has, in the region of maximum deflection on one of said surfaces, an unmetallized area (5) of a roughness Rₐ of < 0.5 µm and a surface extent of ≥ 1 mm.

2. The bending transducer as claimed in claim 1, wherein the ceramic layer with piezoelectric properties has a circular shape and the unmetallized area (5) is located approximately in the center of the circle.

3. The bending transducer as claimed in claim 1, wherein the ceramic layer with piezoelectric properties has the shape of an elongate strip (1, 2) and the unmetallized area (5) is located at a narrow end of the strip.

4. The bending transducer as claimed in claim 3, which is composed of two ceramic layers (1, 2) which are adhesively bonded to one another, are metallized on both sides and have piezoelectric properties and which are polarized in opposite directions and in which the two outer metallizations are connectable to the two poles of an electric voltage source.

5. The bending transducer as claimed in claim 3, which contains two ceramic layers (1, 2) which are adhesively bonded sandwich-like to both sides of a non-conductive molding (3), both layers having contacting (6, 7) taken around and each ceramic layer being connectable to the poles of an electric voltage source.

6. The bending transducer as claimed in claim 3, which contains two ceramic layers (1, 2) which are adhesively bonded sandwich-like to both sides of an electrically conductive two-dimensional molding (3), in particular a metal sheet, both layers being polarized in the same direction, and the conductive molding on the one hand and the two outer metallizations of the ceramic layers on the other hand being connectable to the two poles of an electric voltage source.

7. The bending transducer as claimed in claim 6, wherein the conductive molding is a carbon fiber composite plate having a density of 1.3-1.5 g/cm³.

8. The use of the bending transducer as claimed in claim 1 as a control element in an electrically actuated valve for pressurized gases.

9. A valve which can be actuated piezoelectrically and contains a housing with two valve channels, and
a) a piezoelectric bending transducer as claimed in claim 1, which is clamped in on one side in the interior of the housing and has terminals for connection to an electric voltage source and which is arranged in such a way that, in the absence of an electric voltage, the unmetallized area (5) of the strip (1, 2) touches and closes the first valve channel and on application of a voltage unblocks this valve channel, and
b) a second valve channel (not closed by a valve) through which a pressurized gas can pass into the interior of the housing.

## Revendications

1. Transducteur de pliage piézoélectrique composé d'au moins une couche céramique (1) métallisée sur les deux surfaces extérieures opposées de plus grande dilatation, dotée de propriétés piézoélectriques, qui est polarisée de sorte que, lors de l'application d'un voltage électrique, elle subit une variation en longueur, et d'au moins un objet moulé (2, 3) rigide, lui étant relié en nappe, ayant approximativement les mêmes dimensions de surface qui, lors de l'application d'un voltage électrique, ne subit pas de dilatation en longueur ou subit une dilatation en longueur opposée, caractérisé en ce que la couche céramique dotée de propriétés piézoélectriques présentes dans le domaine de déviation maximale, sur une des surfaces citées présente une zone (5) non métallisée ayant une rugosité Rₐ < 0,5 µm et une dilatation de surface de ≥ 1 mm.

2. Transducteur de pliage selon la revendication 1, caractérisé en ce que la couche céramique dotée de propriétés piézoélectriques présente une forme circulaire, et la zone (5) non métallisée se trouve environ au centre du cercle.

3. Transducteur de pliage selon la revendication 1, caractérisé en ce que la couche céramique dotée de propriétés piézoélectriques présente la forme d'une bande (1, 2) très allongée, et la zone (5) non métallisée se trouve à une extrémité étroite de la bande.

4. Transducteur de pliage selon la revendication 3, caractérisé en ce qu'il se compose de deux couches céramiques (1,2) métallisées des deux côtés, collées l'une sur l'autre, dotées de propriétés piézoélectriques, qui sont inversement polarisées, et dont les deux métallisations extérieures peuvent être reliées aux deux pôles d'une source de voltage électrique.

5. Transducteur de pliage selon la revendication 3, caractérisé en ce qu'il contient deux couches céramiques (1, 2) qui sont collées en sandwich des deux côtés sur un objet moulé (3) non-conducteur, les deux couches présentent une liaison (6, 7) les entourant et chaque couche céramique peut être reliée aux pôles d'une source de voltage électrique.

6. Transducteur de pliage selon la revendication 3, caractérisé en ce qu'il contient deux couches céramiques (1, 2) qui sont collées en sandwich des deux côtés sur un objet moulé (3) planiforme, électro-conducteur, en particulier une plaque métallique, en ce que les deux couches sont polarisées dans la même direction et en ce que l'objet moulé conducteur d'une part, et les deux métallisations extérieures des couches céramiques d'autre part, peuvent être reliés aux deux pôles d'une source de voltage électrique.

7. Transducteur de pliage selon la revendication 6, caractérisé en ce que l'objet moulé conducteur est une plaque mixte de fibre de carbone ayant une densité de 1,3 à 1,5 g/cm³.

8. Utilisation du transducteur de pliage selon la revendication 1 comme élément de commande dans une valve actionnée électriquement pour des gaz comprimés.

9. Valve pouvant être actionnée de manière piézoélectrique comprenant un boîtier comportant deux canaux de valve, et
a) un transducteur de pliage piézoélectrique, selon la revendication 1, encastré d'un côté dans l'espace intérieur du boîtier avec des raccordements pour la liaison avec une source de voltage électrique, qui est agencé de sorte qu'en l'absence d'un voltage électrique, la zone (5) non métallisée de la bande (1, 2) touche et ferme le premier canal de valve, et libère ce canal de valve lorsqu'un voltage est appliquée, et
b) un deuxième canal de valve (non fermé par une valve) à travers lequel un gaz qui est sous pression peut arriver dans l'espace intérieur du boîtier.
